# EUROPÄISCHE PATENTANMELDUNG

(11) **EP 1 132 969 A2**
(43) Veröffentlichungstag der Anmeldung: **12.09.2001**
(21) Anmeldenummer: 01100021.3
(22) Anmeldetag: 04.01.2001
(51) Int. Cl.: H01L 29/06, H01L 29/739

(54) **Halbleiterbauelement**

(30) Priorität: 13.01.2000 DE 10001128
(71) Anmelder: Infineon Technologies AG, 81669 München (DE)
(72) Erfinder: Hirler, Franz, Dr., 84424 Isen (DE)
(74) Vertreter: Reinhard - Skuhra - Weise & Partner

(57) **Zusammenfassung**

Die vorliegende Erfindung schafft ein Halbleiterbauelement mit einem ersten Dotierungsgebiet (20a, 20b) von einem ersten Leitungstyp (n), welches eine Vorderseite und eine Rückseite aufweist; einer vorderseitig in dem ersten Dotierungsgebiet (20a, 20b) eingebrachten ersten Wanne (50) vom zweiten Leitungstyp (p); mindestens einer in der ersten Wanne (50) beabstandet von deren Rand eingebrachten zweiten Wanne (60a, 60b) vom ersten Leitungstyp (n⁺); einem mit der ersten Wanne (50) und mit der zweiten Wanne (60a, 60b) verbundenen ersten Anschluss (C); einem zwischen der zweiten Wanne (60a, 60b) und dem Rand der ersten Wanne (50) liegenden Kanalbereich (45a, 45b); einer isoliert über dem Kanalbereich (45a, 45b) vorgesehenen Gatestruktur (70, 80) mit einem Gateanschluss; einem rückseitig vom ersten Dotierungsgebiet (20a, 20b) vorgesehen zweiten Dotierungsgebiet (40) vom zweiten Leitungstyp (p⁺); und einem mit dem zweiten Dotierungsgebiet (40) verbundenen zweiten Anschluss (E). Das erste Dotierungsgebiet (20a, 20b) weist einen Zwischenbereich (30) auf, welcher das erste Dotierungsgebiet (20a, 20b) in einen rückseitigen ersten und einen vorderseitigen zweiten Teil (20a, 20b) teilt. Der Zwischenbereich (30) ist derart gestaltet, dass er zu einer erheblichen Anhebung der Minoritätsträgerdichte im ersten Teil (20a) des ersten Dotierungsgebiets (20a, 20b).

## Beschreibung

Die vorliegende Erfindung betrifft ein Halbleiterbauelement mit einem ersten Dotierungsgebiet von einem ersten Leitungstyp, welches eine Vorderseite und eine Rückseite aufweist; einer vorderseitig in dem ersten Dotierungsgebiet eingebrachten ersten Wanne vom zweiten Leitungstyp; mindestens einer in der ersten Wanne beabstandet von deren Rand eingebrachten zweiten Wanne vom ersten Leitungstyp; einem mit der ersten Wanne und mit der zweiten Wanne verbundenen ersten Anschluss; einem zwischen der zweiten Wanne und dem Rand der ersten Wanne liegenden Kanalbereich; einer isoliert über dem Kanalbereich vorgesehenen Gatestruktur mit einem Gateanschluss; einem rückseitig vom ersten Dotierungsgebiet vorgesehen zweiten Dotierungsgebiet vom zweiten Leitungstyp; und einem mit dem zweiten Dotierungsgebiet verbundenen zweiten Anschluss.

Obwohl auf beliebige Halbleiterbauelemente anwendbar, werden die vorliegende Erfindung sowie die ihr zu Grunde liegende Problematik in Bezug auf vertikale IGBT-Transistoren erläutert.

Bei der Entwicklung neuer Generationen von IGBT's (Insulated Gate Bipolar Transistor) ist ein wichtiges Ziel die Verringerung der Kollektor-Emitter-Spannung im Durchlassfall beim Nennstrom V_{CESat}. Damit kann einerseits die statische Verlustleitung minimiert werden, und andererseits lassen sich höhere Stromdichten erreichen, wodurch kleinere, also billigere Chips für den gleichen Gesamtstrom verwendet werden können.

Eine niedrige Kollektor-Emitter-Spannung V_{CESat} lässt sich üblicherweise durch Optimierung der vertikalen Struktur des Bauelements erreichen. Hierzu gehören Scheibendicke, Grunddotierung, Dotierung der Rückseite (p-Emitter, gegebenenfalls n-Buffer) sowie die Ladungsträger-Lebensdauer. Wünschenswert wäre eine Optimierung unabhängig von diesen Parametern, die zur Optimierung der vertikalen Struktur und zu einer deutlichen Verbesserung der Kollektor-Emitter-Spannung V_{CESat} führt.

Ein weiteres bekanntes Verfahren, die Kollektor-Emitter-Spannung im Durchlassfall im Vergleich zu üblichen planaren IGBT's zu verringern, besteht darin, von der planaren Zellenstruktur abzugehen und Trenchzellen zu verwenden. Siehe dazu beispielsweise M. Harada et al., "600V Trench IGBT in Comparison with Planer IGBT", Proc. of 6^{th} ISPSD, Seiten 411 bis 416, 1999. Der Nachteil dieses Verfahrens besteht darin , dass zum einen im Trench eine hohe Gateoxidqualität erheblich schwieriger zu erreichen ist als auf einer planaren Oberfläche und zum anderen das Eintauchen der Silizium-Oxidgrenzfläche in den Trenches tief unter das Bodygebiet ohne zusätzliche Maßnahmen zwangsläufig zu elektrischen Feldspitzen in der Nähe des Gateoxides führt, welche unter extremen Betriebsbedingungen zur Zerstörung des Bauelements führen können.

Aus der US-A-5,028,973 ist es bekannt, dass die Emittereffizienz eines Bipolartransistors dadurch erhöht werden kann, dass der Emitter zweischichtig ausgeführt wird, wobei eine Schicht als Barrierenschicht für Minoritätsträger wirkt.

Aus der US-A-5,378,923 ist es bekannt, dass der Sourcebereich eines MOS-Transistors zweischichtig ausgeführt wird, um eine Bandmodulation zu bewirken.

Daher ist es Aufgabe der vorliegenden Erfindung, das eingangs erwähnte Halbleiterbauelement derart weiterzuentwickeln, dass die Kollektor-Emitter-Spannung im Durchlassfall beim Nennstrom im Vergleich zu üblichen planaren IGBT's deutlich verringerbar ist, ohne die Durchbruchspannung des Bauelements herabzusetzen.

Erfindungsgemäß wird diese Aufgabe durch das in Anspruch 1 angegebene Halbleiterbauelement gelöst.

Die der vorliegenden Erfindung zugrundeliegende Idee besteht darin, dass das erste Dotierungsgebiet einen Zwischenbereich aufweist, welcher das erste Dotierungsgebiet in einen rückseitigen ersten und einen vorderseitigen zweiten Teil teilt; und dass der Zwischenbereich derart gestaltet ist, dass er eine lokale Absenkung der Valenzbandoberkante bewirkt und die Leitungsbandunterkante im wesentlich nicht absenkt.

Erfindungsgemäß wird also eine Struktur vorgeschlagen, die durch einen Zwischenbereich, z.B. eine zusätzliche Schicht aus einem zweiten Halbleitermaterial mit tieferliegendem Valenzband nahe der Kollektorseite, einen Widerstand für die Minoritätsträger darstellt und so zu einer erheblichen Anhebung der Minoritätsträgerdichte an der Kollektorseite des Halbleiterbauelements führt, was eine entsprechende Reduzierung der Durchlassspannung V_{CESat} zur Folge hat.

Das erfindungsgemäße Halbleiterbauelement weist somit gegenüber den bekannten Lösungsansätzen den Vorteil auf, dass sie eine zusätzliche Optimierungsmöglichkeit für die Kollektor-Emitter-Spannung im Durchlassfall beim Nennstrom angibt.

In den Unteransprüchen finden sich vorteilhafte Weiterbildungen und Verbesserungen des in Anspruch 1 angegebenen Halbleiterbauelements.

Gemäß einer bevorzugten Weiterbildung bewirkt der Zwischenbereich eine lokale Absenkung der Valenzbandoberkante, wobei die Leitungsbandunterkante im wesentlich nicht abgesenkt wird.

Gemäß einer weiteren bevorzugten Weiterbildung ist der Zwischenbereich eine zusätzliche Schicht aus einem vom Grundmaterial des Halbleiterbauelements verschiedenen zweiten vorzugsweise kristallinen Halbleitermaterial mit tieferliegendem Valenzband.

Gemäß einer weiteren bevorzugten Weiterbildung ist der Zwischenbereich eine zusätzliche Schicht aus einem vorzugsweise kristallinen Isolatormaterial mit tieferliegendem Valenzband.

Gemäß einer weiteren bevorzugten Weiterbildung ist der Zwischenbereich unterbrochen, so dass der erste und zweite Teil stellenweise zusammenhängen.

Gemäß einer weiteren bevorzugten Weiterbildung ist der Zwischenbereich nahe der Seite mit der ersten Wanne angeordnet, so dass der erste Teil eine wesentlich größere Dicke als der zweite Teil aufweist.

Gemäß einer weiteren bevorzugten Weiterbildung sind zwei zweite Wannen vom ersten Leitungstyp in der ersten Wanne beabstandet von deren Rand eingebracht.

Gemäß einer weiteren bevorzugten Weiterbildung ist das Grundmaterial des Halbleiterbauelements Silizium.

Gemäß einer weiteren bevorzugten Weiterbildung ist der erste Leitungstyp n und der zweite Leitungstyp p.

Ausführungsbeispiele der Erfindung sind in den Zeichnungen dargestellt und in der nachfolgenden Beschreibung näher erläutert.

Es zeigen:

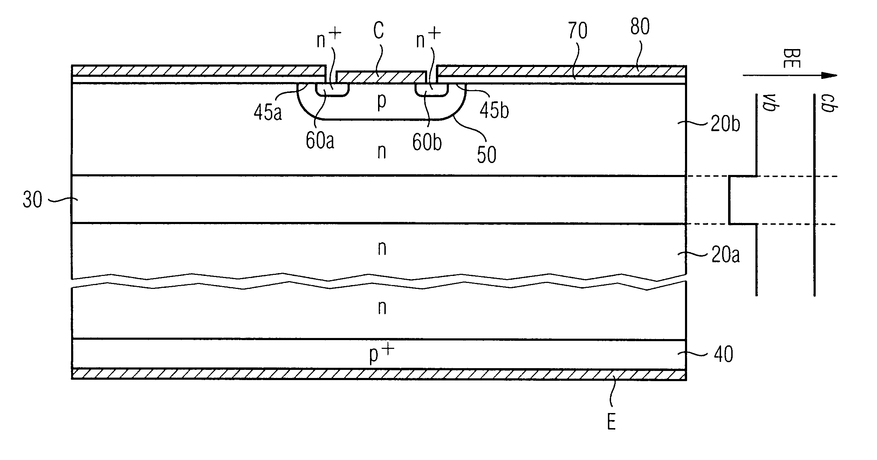

- Fig. 1: eine schematische Darstellung eines Halbleiterbauelements als Ausführungsform der vorliegenden Erfindung.

Das Halbleiterbauelement gemäß dieser Ausführungsform ist ein IGBT mit planarer Gatestruktur in Siliziumtechnologie. Es weist ein zweiteiliges erstes Dotierungsgebiet 20a, 20b von einem ersten Leitungstyp n als n-Basis auf.

Vorderseitig in dem ersten Dotierungsgebiet 20a, 20b eingebracht ist eine erste Wanne 50 vom zweiten Leitungstyp p als p-Basis. Zwei zweite Wannen 60a, 60b vom ersten Leitungstyp n⁺ sind als n⁺-Source in der ersten Wanne 50 beabstandet von deren Rand eingebracht. Ein Kollektoranschluss C dient zum Anschluss der beiden zweiten Wannen 60a, 60b und der ersten Wanne 50.

Zwischen der jeweiligen zweiten Wanne 60a, 60b und dem Rand der ersten Wanne 50 liegt ein jeweiliger Kanalbereich 45a, 45b, und isoliert über dem jeweiligen Kanalbereich 45a, 45b vorgesehen ist eine Gatestruktur einschließlich einer Isolationsschicht 70 und einer Gateanschlussschicht 80.

Rückseitig vom ersten Teil 20a des ersten Dotierungsgebiets vorgesehen ist ein zweites Dotierungsgebiet 40 vom zweiten Leitungstyp p⁺ als p⁺-Emitter mit einem entsprechenden Emitteranschluss (E).

Etwas unterhalb der ersten Wanne 50 ist einkristallin eine Schicht aus einem zweiten Halbleitergrundmaterial in das erste Dotierungsgebiet 10a, 20b eingefügt, das ein Leitungsband cb derselben Energie aufweist, aber ein tieferliegendes Valenzband vb, so dass es an der Grenzfläche zu einem Sprung im Valenzband kommt, der eine Barriere für die Löcher (Minoritätsträger) darstellt, wie anhand der Bandenergie BE dargestellt.

Dies führt zu einer erheblichen Anhebung der Minoritätsträgerdichte an der Emitterseite des Halbleiterbauelements, was eine entsprechende Reduzierung der Durchlassspannung V_{CE-} _{Sat} zur Folge hat.

Für diese Struktur nach Figur 1 wurden Simulationen durchgeführt. Danach lässt sich die Kollektor-Emitter-Spannung im Durchlassfall um bis zu 1,2 Volt gegenüber einem Standarddesign ohne Zwischenschicht reduzieren, wenn die Barrierenhöhe im Valenzband von 120 mV modifiziert wird.

Obwohl die vorliegende Erfindung vorstehend anhand bevorzugter Ausführungsbeispiele beschrieben wurde, ist sie darauf nicht beschränkt, sondern auf vielfältige Art und Weise modifizierbar.

Auch kann das erfindungsgemäße Halbleiterbauelement Teil einer Thyristorstruktur oder sonstigen komplizierteren Bauelementstruktur sein und ist nicht auf den erläuterten vertikalen IGBT-Transistor beschränkt.

Die IGBT-Transistorzelle kann selbst als eine herkömmliche planare Zelle oder auch als Trenchzelle ausgeführt sein. Die vertikale Struktur kann im punch-through-Design oder im non-punch-trough-Design verwirklicht sein.

Der Zwischenbereich muss nicht aus einem Halbleitermaterial bestehen, sondern kann eine Isolatormaterialschicht aufwiesen. Da Isolatormaterialien üblicherweise eine zu hohe Barriere für Elektronen aufweisen, so kann diese Schicht unterbrochen sein, um einen möglichst ungehinderten Elektronenfluss sicherzustellen.

### BEZUGSZEICHENLISTE:

- 20 a, 20b: erster Dotierungsbereich
- 40: zweiter Dotierungsbereich
- 50: erste Wanne
- 60a, 60b: zweite Wanne
- 45a, 45b: Kanalbereich
- E: rückseitiger Anschlußbereich
- c: vorderseitiger Anschlußbereich
- 70: Isolationsschicht
- 80: Gatebereich
- BE: Bandenergie
- cb: Leitungsbandunterkante
- vb: Valenzbandoberkante

## Patentansprüche

1. Halbleiterbauelement mit:
einem ersten Dotierungsgebiet (20a, 20b) von einem ersten Leitungstyp (n), welches eine Vorderseite und eine Rückseite aufweist;
einer vorderseitig in dem ersten Dotierungsgebiet (20a, 20b) eingebrachten ersten Wanne (50) vom zweiten Leitungstyp (p);
mindestens einer in der ersten Wanne (50) beabstandet von deren Rand eingebrachten zweiten Wanne (60a, 60b) vom ersten Leitungstyp (n⁺) ;
einem mit der ersten Wanne (50) und mit der zweiten Wanne (60a, 60b) verbundenen ersten Anschluss (C);
einem zwischen der zweiten Wanne (60a, 60b) und dem Rand der ersten Wanne (50) liegenden Kanalbereich (45a, 45b);
einer isoliert über dem Kanalbereich (45a, 45b) vorgesehenen Gatestruktur (70, 80) mit einem Gateanschluss;
einem rückseitig vom ersten Dotierungsgebiet (20a, 20b) vorgesehen zweiten Dotierungsgebiet (40) vom zweiten Leitungstyp (p⁺) ; und
einem mit dem zweiten Dotierungsgebiet (40) verbundenen zweiten Anschluss (E);
**dadurch gekennzeichnet**,
dass das erste Dotierungsgebiet (20a, 20b) einen Zwischenbereich (30) aufweist, welcher das erste Dotierungsgebiet (20a, 20b) in einen rückseitigen ersten und einen vorderseitigen zweiten Teil (20a, 20b) teilt; und
der Zwischenbereich (30) derart gestaltet ist, dass er zu einer erheblichen Anhebung der Minoritätsträgerdichte im ersten Teil (20a) des ersten Dotierungsgebiets (20a, 20b) führt.

2. Halbleiterbauelement nach Anspruch 1,
**dadurch gekennzeichnet,**
dass der Zwischenbereich (30) eine lokale Absenkung der Valenzbandoberkante (vb) bewirkt und die Leitungsbandunterkante (cb) im wesentlich nicht absenkt.

3. Halbleiterbauelement nach Anspruch 1 oder 2,
**dadurch gekennzeichnet,**
dass der Zwischenbereich (30) eine zusätzliche Schicht aus einem vom Grundmaterial des Halbleiterbauelements verschiedenen zweiten vorzugsweise kristallinen Halbleitermaterial mit tieferliegendem Valenzband ist.

4. Halbleiterbauelement nach Anspruch 1 oder 2,
**dadurch gekennzeichnet,**
dass der Zwischenbereich (30) eine zusätzliche Schicht aus einem vorzugsweise kristallinen Isolator-material mit tieferliegendem Valenzband ist.

5. Halbleiterbauelement nach Anspruch 1, 2, 3 oder 4,
**dadurch gekennzeichnet,**
dass der Zwischenbereich (30) unterbrochen ist, so dass der erste und zweite Teil (20a, 20b) stellenweise zusammenhängen.

6. Halbleiterbauelement nach einem der vorhergehenden Ansprüche,
**dadurch gekennzeichnet,**
dass der Zwischenbereich nahe der Seite mit der ersten Wanne (50) angeordnet ist, so dass der erste Teil (20a) eine wesentlich größere Dicke als der zweite Teil (20b) aufweist.

7. Halbleiterbauelement nach einem der vorhergehenden Ansprüche,
**dadurch gekennzeichnet,**
dass zwei zweite Wannen (60a, 60b) vom ersten Leitungstyp (n⁺) in der ersten Wanne (50) beabstandet von deren Rand eingebracht sind.

8. Halbleiterbauelement nach einem der vorhergehenden Ansprüche,
**dadurch gekennzeichnet,**
dass das Grundmaterial des Halbleiterbauelements Silizium ist.

9. Halbleiterbauelement nach einem der vorhergehenden Ansprüche,
**dadurch gekennzeichnet,**
dass der erste Leitungstyp n und der zweite Leitungstyp p ist.
